# EUROPÄISCHE PATENTANMELDUNG

(11) **EP 3 462 193 A1**
(43) Veröffentlichungstag der Anmeldung: **03.04.2019**
(21) Anmeldenummer: 17201111.6
(22) Anmeldetag: 10.11.2017
(51) Int. Cl.: G01R 31/04

(54) **VERFAHREN ZUR INSTALLATION EINES ANTRIEBSSYSTEMS UND ANTRIEBSSYSTEM**

(30) Priorität: 29.09.2017 EP 17194070
(71) Anmelder: Siemens Aktiengesellschaft, 80333 München (DE)
(72) Erfinder: Heinemann, Gerhard, 91058 Erlangen (DE); Namyslo, Lutz, 91353 Hausen (DE); Donat, Albrecht, 91462 Dachsbach (DE); Fries, Edgar, 91077 Neunkirchen am Brand (DE); Lorz, Roland, 91341 Röttenbach (DE)

(57) **Zusammenfassung**

Die Erfindung betrifft ein Verfahren zum Anschluss eines Antriebssystems und ein Antriebssystem. Das Antriebssystem umfasst eine Spannungsquelle (1) und einen Verbraucher (5). Der Verbraucher (5) ist über eine elektrische Leitung (3) mit der Spannungsquelle (1) verbunden. Beim Anschluss des Verbrauchers (5) an die Spannungsquelle (1) stellt die Spannungsquelle (1) ein Analysesignal dem Verbraucher (5) bereit. Insbesondere mit Hilfe einem Anzeigemodul (11) wird eine Information (9) angezeigt, ob die jeweilige Spannungsphase (u, v, w) gemäß einer vorgegebenen Anschlussbelegung (9) angeschlossen ist. Der Verbraucher (5) weist optional eine Kennung (7) auf. Die Kennung (7) und/oder die Anschluss-Informationen (9) werden vorteilhaft der Spannungsquelle (1) bereitgestellt. Vorteilhaft kann die Spannungsquelle (1) anhand des jeweils angeschlossenen Verbrauchers (5) die Spannungsphasen (u, v, w) anpassen.

## Beschreibung

Die Erfindung betrifft ein Verfahren zur Installation eines Antriebssystems und ein Antriebssystem.

Für den Anschluss eines Verbrauchers an eine Spannungsquelle ist insbesondere bei langen elektrischen Leitungen eine Kontrolle der richtigen Anschlussbelegung notwendig, insofern keine eindeutige (Steck-)Verbindung vorliegt. Insbesondere im industriellen Umfeld sind die elektrischen Leitungen oft sehr lang. Längen von elektrischen Leitungen zwischen einem technischen Gerät und der Spannungsquelle bis 100 Meter und darüber hinaus sind keine Seltenheit. Die Elektrische Leitung für eine Mehrphasenwechselspannung umfasst in der Regel eine Mehrzahl einzelner Leitungen zum Anschluss an den Verbraucher. Die einzelnen Leitungen werden auch als Spannungsphasen bezeichnet.

Beim Anschluss des Verbrauchers an eine Mehrphasenwechselspannung sind daher besondere Kontrollen notwendig wie das manuell durchgeführte "Durchklingeln" der Elektrische Leitung bzw. einer Spannungsphase. Diese Kontrollen sind zeitaufwändig und erfordern hohes fachliches Können.

Ein der Erfindung ähnliches System ist in DE 10 2010 050 785 A1 offenbart.

Daher ist es Aufgabe der Erfindung, eine Installation eines technischen Gerätes an eine Spannungsquelle zu vereinfachen.

Die Aufgabe wird durch ein Verfahren nach Anspruch 1 gelöst.

Die Aufgabe wird weiter durch ein Antriebssystem nach Anspruch 8 gelöst.

Vorteilhafte Ausführungen und Weiterentwicklungen sind Gegenstand der abhängigen Ansprüche.

Bei dem Verfahren zur Installation eines Antriebssystems, weist das Antriebssystem eine Spannungsquelle, insbesondere ein Frequenzumrichter, und einen Verbraucher, insbesondere einen Motor, auf, wobei der Verbraucher über eine Leitung verbunden ist, wobei die elektrische Leitung eine Mehrzahl von Spannungsphasen umfasst, wobei die jeweilige Spannungsphase anhand einer vorgegebenen Anschlussbelegung an dem Verbraucher anzuschließen ist,
- wobei in einem Schritt die jeweilige Spannungsphase der elektrischen Leitung an den Verbraucher angeschlossen wird,
- wobei in einem weiteren Schritt die Spannungsquelle dem Verbraucher ein Analysesignal über die elektrische Leitung bereitstellt,
- wobei in einem weiteren Schritt anhand des Analysesignals geprüft wird, ob die jeweilige Spannungsphase gemäß einer vorgegebenen Anschlussbelegung an den Verbraucher angeschlossen ist,
- wobei in einem weiteren Schritt anhand der Prüfung, ob die jeweilige Spannungsphase anhand der vorgegebenen Anschlussbelegung angeschlossen ist, eine Information von dem ersten Kommunikationsmodul bereitgestellt wird,
wobei die Information mit einem Anzeigemodul angezeigt wird.

Bei dem Verfahren zur Installation eines Antriebssystems wird insbesondere der Vorgang des Anschlusses des Verbrauchers an die elektrische Leitung betrachtet. In der Regel liegen die einzelnen Spannungsphasen als lose Anschlusskabel vor, die jeweils mit dem jeweils dafür vorgesehenen Anschluss des Verbrauchers verbunden werden. Um beim Anschluss der elektrische leitung Fehler zu vermeiden findet mit den hier beschriebenen Verfahren eine Prüfung statt, ob der Anschluss richtig erfolgt.

Das Analysesignal kann jeweils ein Signal sein, in dem die jeweilige Spannungsphase codiert ist. Vorzugsweise wird ein Vergleich des jeweiligen Analysesignals mit der jeweils vorliegenden Anschlussbelegung verglichen.

Im Falle einer Abweichung kann angezeigt werden, welche Spannungsphase(n) nicht gemäß der vorgesehenen Anschlussbelegung angeschlossen ist. Im Falle einer Übereinstimmung der Anschlussbelegung der jeweiligen Spannungsphase mit der vorgesehenen Anschlussbelegung kann dies ebenfalls angezeigt werden. Zur Anzeige kann beispielhaft eine Leuchtdiode dienen, die bei Übereinstimmung der Anschlussbelegung mit der vorgesehenen Anschlussbelegung grün leuchtet und ansonsten ein rotes Signal ausgibt.

Weiter kann die Anzeige auch mit Hilfe eines Anzeigemoduls erfolgen.

Bei einer vorteilhaften Ausgestaltung der Erfindung weist die Spannungsquelle ein zweites Kommunikationsmodul auf, wobei dem Verbraucher eine Kennung zugeordnet ist, wobei mit Hilfe des ersten Kommunikationsmoduls der Information die Kennung beigefügt wird, wobei mit Hilfe des ersten Kommunikationsmoduls und des zweiten Kommunikationsmoduls die Information an die Spannungsquelle übertragen wird.

Bei einer weiteren vorteilhaften Ausgestaltung der Erfindung werden anhand der Information die Einstellungen der Spannungsquelle, insbesondere eine Zuordnung der Spannungsphasen, verändert.

Bei einer weiteren vorteilhaften Ausgestaltung der Erfindung beeinflusst das Analysesignal den Zustand des Verbrauchers nicht oder nur unwesentlich.

Bei einer weiteren vorteilhaften Ausgestaltung der Erfindung wird die Information alternativ oder zusätzlich einer dezentralen Recheneinheit, insbesondere einer Cloud, bereitgestellt.

Bei einer weiteren vorteilhaften Ausgestaltung der Erfindung wird das erste Kommunikationsmodul von der Spannungsquelle mit elektrischer Energie versorgt, insbesondere mit dem Analysesignal.

Bei einer weiteren vorteilhaften Ausgestaltung der Erfindung, wird die Information über eine drahtlose Datenverbindung übertragen. Die Übertragung erfolgt insbesondere durch eine Datenverbindung nach einem GSM-Standard, nach einem G3, nach einem G4, nach einem G5-Standard oder über einer WLAN Verbindung.

Das Antriebssystem weist eine Spannungsquelle, insbesondere einen Frequenzumrichter, und einen Verbraucher, insbesondere einen Motor, auf, wobei der Verbraucher durch eine Elektrische Leitung mit der Spannungsquelle verbunden ist, wobei dem Verbraucher ein erstes Kommunikationsmodul zugeordnet ist, wobei die Spannungsquelle zur Bereitstellung eines Analysesignals vorgesehen ist, wobei die Elektrische Leitung eine Mehrzahl von Spannungsphasen umfasst,
wobei das erste Kommunikationsmodul zu einer Überprüfung einer Anschlussbelegung an dem Verbraucher mit Hilfe des Analysesignals vorgesehen ist, ob die Anschlussbelegung der jeweiligen Spannungsphase der vorgesehenen Anschlussbelegung entspricht,
wobei das erste Kommunikationsmodul zur Bereitstellung einer Information anhand der Prüfung vorgesehen ist, wobei ein Anzeigemodul zur Anzeige der Information vorgesehen ist.

Bei einer weiteren vorteilhaften Ausgestaltung der Erfindung ist das Anzeigemodul als mobiles Anzeigemodul, insbesondere als Smartphone, ausgebildet.

Bei einer weiteren vorteilhaften Ausgestaltung der Erfindung weisen der Verbraucher und/oder das erste Kommunikationsmodul eine Kennung auf, wobei die Kennung zur Bereitstellung mit der Information vorgesehen ist.

Bei einer weiteren vorteilhaften Ausgestaltung der Erfindung ist die Kennung mit dem Anzeigemodul direkt erfassbar.

Bei einer weiteren vorteilhaften Ausgestaltung der Erfindung ist ein Spannungsteiler zur Spannungsversorgung des ersten Kommunikationsmoduls vorgesehen, wobei der Spannungsteiler an die elektrische Leitung angeschlossen ist.

Bei einer weiteren vorteilhaften Ausgestaltung der Erfindung weist die Spannungsquelle ein zweites Kommunikationsmodul auf, wobei das zweite Kommunikationsmodul zum Empfang der Information ausgebildet ist.

Bei einer weiteren vorteilhaften Ausgestaltung der Erfindung sind das erste Kommunikationsmodul und das zweite Kommunikationsmodul zur Übertragung von Informationen über das Anzeigemodul ausgebildet.

Bei einer weiteren vorteilhaften Ausgestaltung der Erfindung weist das zweite Kommunikationsmodul einen Energiespeicher auf, wobei die elektrische Leitung, insbesondere über einen Spannungswandler, den Energiespeicher mit einer Spannung versorgt.

Im Folgenden wird die Erfindung anhand von Figuren weiter beschrieben und erläutert. Hierbei zeigen:
- FIG 1: ein beispielhaftes Antriebssystem,
- FIG 2: ein weiteres beispielhaftes Antriebssystem sowie
- FIG 3: ein weiteres beispielhaftes Antriebssystem mit einer dezentralen Recheneinheit.

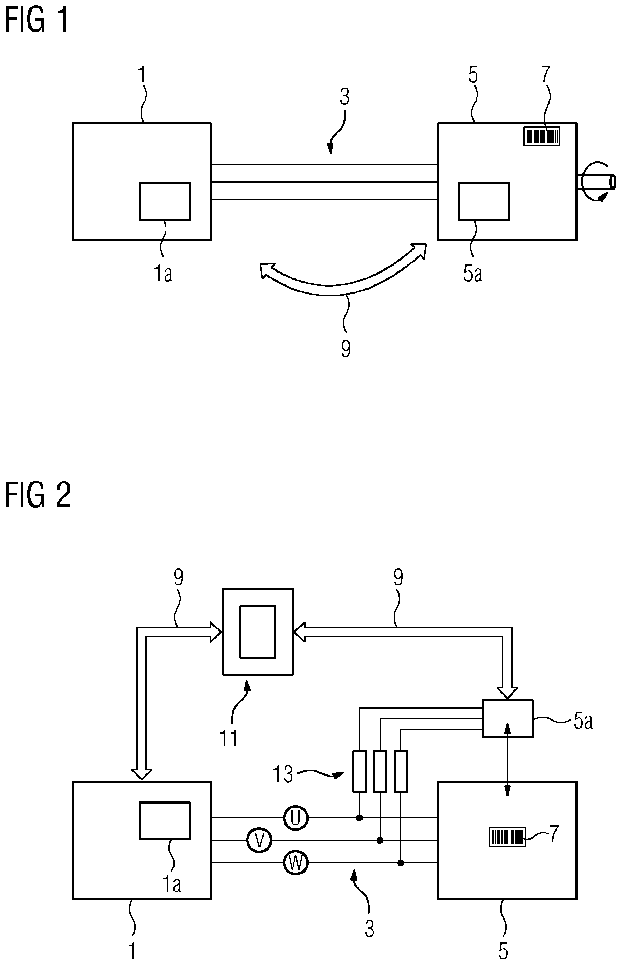

FIG 1 zeigt ein beispielhaftes Antriebssystem. Das hier gezeigte Antriebssystem weist als Spannungsquelle 1 einen Frequenzumrichter auf. Die Spannungsquelle 1 ist mit dem Verbraucher 5 über eine elektrische Leitung 3 verbunden. Die elektrische Leitung 3 dient zur Übertragung der Spannung für den Verbraucher. Der Verbraucher 5 ist hier als Motor dargestellt.

Dem Verbraucher 5 ist eine Kennung 7 zugeordnet. Die Kennung 7 dient zur Identifikation des Verbrauchers 5. Die Kennung 7 weist technische Daten des Verbrauchers 5 auf. Dem Verbraucher 5 ist ein erstes Kommunikationsmodul 5a zugeordnet. Das erste Kommunikationsmodul 5a kann als Mikrocomputer ausgeführt sein. Das erste Kommunikationsmodul 5a dient zur Übertragung einer Information 9 zu einem zweiten Kommunikationsmodul 1a. Die Information 9 wird vorzugsweise drahtlos, beispielhaft durch WLAN, übertragen.

Das zweite Kommunikationsmodul 1a ist der Spannungsquelle 1 zugeordnet. Die Kommunikationsmodule dienen zur Übertragung der Kennung 7 des Verbrauchers 5 an die Spannungsquelle 1. Anhand der Kennung 7, die als Information 9 der Spannungsquelle 1 bereitgestellt wird, werden Einstellungen der Spannungsquelle 1, wie jeweilige Spannungsphase u, v, w, festgelegt. Eine Einstellung der jeweiligen Spannungsphase u, v, w kann die Spannung oder eine Phasenverschiebung einer Mehrphasen-Wechselspannung sein, der von der Spannungsquelle 1 dem Verbraucher 5 bereitgestellt wird.

Beim Anschluss des Verbrauchers 5 an die elektrische Leitung 3 werden die Informationen 9 des Anschlusses mit Hilfe des ersten Kommunikationsmoduls 5a an das zweite Kommunikationsmodul 1a bereitgestellt. Die Information 9 umfasst, ob die jeweilige Spannungsphase u, v, w gemäß der festgelegten Anschlussbelegung am Verbraucher angeschlossen ist. Die Überprüfung, on die Anschlussbelegung der Spannungsphasen u, v, w richtig ist, erfolgt vorteilhaft durch die Messung der Phasenbeziehung einzelnen Spannungsphasen u, v, w zueinander. Falls die jeweilige Spannungsphase u, v, q nicht gemäß der vorgesehenen Anschlussbelegung am Verbraucher angeschlossen ist, kann die Spannungsquelle die jeweilige Spannungsphase u, v, w wechseln und so eine falsch angeschlossene elektrische Leitung 3 korrigieren.

FIG 2 zeigt ein weiteres beispielhaftes Antriebssystem. Das gezeigte Antriebssystem weist eine Spannungsquelle 1 und einen Verbraucher 5 auf. Der Verbraucher ist über eine elektrische Leitung 3 mit der Spannungsquelle 1 verbunden. Die elektrische Leitung 3 umfasst drei Phasen u, v, w. Die erste Phase u ist die erste Phase einer 3-Phasen-Wechselspannung. Dasselbe gilt auch für die zweite Phase v und die dritte Phase w.

Dem Verbraucher 5 ist ein erstes Kommunikationsmodul 5a zugeordnet. Das erste Kommunikationsmodul 5a ist über einen Spannungsteiler 13 mit der elektrischen Leitung 3 verbunden. Das erste Kommunikationsmodul 5a stellt die Information 9 für ein Anzeigemodul 11 bereit. Das Anzeigemodul 11 ist vorzugsweise als mobiles Human-Machine-Interface (mobiles HMI) ausgebildet. Das Anzeigemodul 11 dient zur Anzeige der Information 9.

Die Information ist insbesondere eine Anschluss-Information. Beim Anschluss des Verbrauchers 5 an die elektrische Leitung 3 stellt das erste Kommunikationsmodul 5a die Information 9 bezüglich des Anschlusses einem zweiten Kommunikationsmodul 1a bereit. Das zweite Kommunikationsmodul 1a ist der Spannungsquelle 1 zugeordnet.

Nach dem Anschluss des Verbrauchers 5 an die elektrische Leitung 3 wird, vorzugsweise mit Hilfe der Kommunikationsmodule 1a, 5a, ein Signal an die Spannungsquelle 1 übertragen. Die Spannungsquelle 1 stellt durch die elektrische Leitung 3 einen Analysestrom bereit. Anhand der Analysespannung stellt das Kommunikationsmodul fest, ob der Anschluss des Verbrauchers 5 an die elektrische Leitung 3 richtig erfolgt ist. Das Ergebnis der Feststellung wird durch das Anzeigemodul 11 angezeigt und der Spannungsquelle 1 bereitgestellt. Die Spannungsversorgung des ersten Kommunikationsmoduls 5a erfolgt, insbesondere durch die Analysespannung, der mittels des Spannungsteilers zum Teil dem ersten Kommunikationsmodul 5a bereitgestellt wird.

Mit Hilfe des Anzeigemoduls kann auch eine Kennung 7 des Verbrauchers 5 aufgenommen werden. Die Kennung 7 ist vorzugsweise als QR-Code auf dem Verbraucher 5 angebracht. Mit dem Anzeigemodul 11 kann die Kennung 7 aufgenommen werden und wird als Information 9 über das zweite Kommunikationsmodul 1a an die Spannungsquelle 1 bereitgestellt. Die Kennung 7 kann auch direkt mit Hilfe der Kommunikationsmodule 1a, 5a der Spannungsquelle 1 bereitgestellt werden.

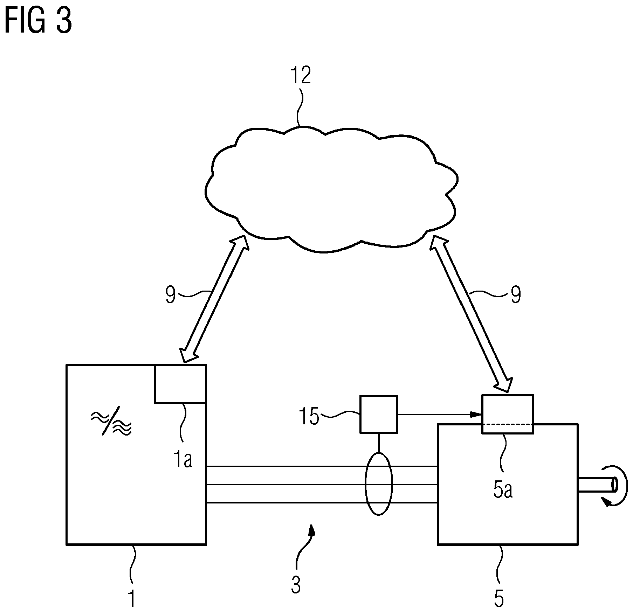

FIG 3 zeigt ein weiteres Antriebssystem mit einer dezentralen Recheneinheit 12. Die dezentrale Recheneinheit 12 umfasst vorzugsweise einen Speicher zur Speicherung von Informationen 9. Die Information 9 für die dezentrale Recheneinheit 12 wird von dem ersten Kommunikationsmodul 5a und/oder dem zweiten Kommunikationsmodul 1a bereitgestellt. Die dezentrale Recheneinheit 12 kann als Cloud oder als ein Intranet/Internet ausgeführt sein.

Der Verbraucher 5, hier als Motor ausgeführt, wird durch die eektrische Leitung 3 mit der Spannungsquelle 1, hier als Frequenzumrichter dargestellt, verbunden. Der Verbraucher 5 umfasst das erste Kommunikationsmodul 5a. Die Spannungsquelle 1 umfasst das zweite Kommunikationsmodul 1a. Das erste Kommunikationsmodul 5a ist mit einem Energiespeicher 15 verbunden. Der Energiespeicher 15 wird von der elektrischen Leitung 3 mit elektrischer Energie versorgt. Der Energiespeicher 15 dient als Sammelstelle von elektrischer Energie, wobei die elektrische Energie dem ersten Kommunikationsmodul 5a bereitgestellt wird.

Die Information 9, die mit Hilfe des ersten Kommunikationsmoduls 5a an die dezentrale Recheneinheit 12 bereitgestellt wird, umfasst die Kennung 7 des Verbrauchers. Das erste Kommunikationsmodul 5a weist die Kennung 7 des Verbrauchers 5 auf und überträgt die Kennung 7 zumindest als Teil der Information 9 an die dezentrale Recheneinheit 12 und/oder an das zweite Kommunikationsmodul 1a.

Zusammenfassend betrifft die Erfindung ein Verfahren zum Anschluss eines Antriebssystems und ein Antriebssystem. Das Antriebssystem umfasst eine Spannungsquelle 1 und einen Verbraucher 5. Der Verbraucher 5 ist über eine elektrische Leitung 3 mit der Spannungsquelle 1 verbunden. Beim Anschluss des Verbrauchers 5 an die Spannungsquelle 1 stellt die Spannungsquelle 1 ein Analysesignal dem Verbraucher 5 bereit. Insbesondere mit Hilfe eines Anzeigemoduls 11 wird eine Information 9 angezeigt, ob die jeweilige Spannungsphase u, v, w gemäß einer vorgegebenen Anschlussbelegung 9 angeschlossen ist. Der Verbraucher 5 weist optional eine Kennung 7 auf. Die Kennung 7 und/oder die Anschluss-Informationen 9 werden vorteilhaft der Spannungsquelle 1 bereitgestellt. Vorteilhaft kann die Spannungsquelle 1 anhand des jeweils angeschlossenen Verbrauchers 5 die Spannungsphasen u, v, w anpassen.

## Patentansprüche

1. Verfahren zur Installation eines Antriebssystems, aufweisend eine Spannungsquelle (1), insbesondere einen Frequenzumrichter, und einen Verbraucher (5), insbesondere einen Motor, wobei der Verbraucher (5) über eine elektrische Leitung (3) mit einer Spannungsquelle (1) verbunden ist, wobei die elektrische Leitung (3) eine Mehrzahl von Spannungsphasen (u, v, w) umfasst, wobei die jeweilige Spannungsphase (u, v, w) anhand einer vorgegebenen Anschlussbelegung an dem Verbraucher (5) anzuschließen ist,
- wobei in einem Schritt die jeweilige Spannungsphase (u, v, w) der elektrische Leitung (3) an den Verbraucher (5) angeschlossen wird,
- wobei in einem weiteren Schritt die Spannungsquelle (1) dem Verbraucher (5) ein Analysesignal über die elektrische Leitung (3) bereitstellt,
- wobei in einem weiteren Schritt anhand des Analysesignals geprüft wird, ob die jeweilige Spannungsphase (u, v, w) gemäß der vorgegeben Anschlussbelegung an den Verbraucher (5) angeschlossen ist,
- wobei in einem weiteren Schritt anhand der Prüfung, ob die jeweilige Spannungsphase (u, v, w) anhand der vorgegebenen Anschlussbelegung angeschlossen ist, eine Information (9) von dem ersten Kommunikationsmodul (5a) bereitgestellt wird,
wobei die Information (9)vorzugsweise mit einem Anzeigemodul (11) angezeigt wird.

2. Verfahren nach Anspruch 1, wobei die Spannungsquelle (1) ein zweites Kommunikationsmodul (1a) aufweist, wobei dem Verbraucher (5) eine Kennung (7) zugeordnet ist, wobei mit Hilfe des ersten Kommunikationsmoduls (5a) der Information (9) die Kennung (7) beigefügt wird, wobei mit Hilfe des ersten Kommunikationsmoduls (5a) und des zweiten Kommunikationsmoduls (1a) die Information (9) an die Spannungsquelle (1) übertragen wird.

3. Verfahren nach einem der vorangehenden Ansprüche, wobei anhand der Information (9) die Einstellungen der Spannungsquelle (1), insbesondere eine Zuordnung der Spannungsphasen (u, v, w), verändert werden.

4. Verfahren nach einem der vorangehenden Ansprüche, wobei das Analysesignal den Zustand des Verbrauchers (5) nicht beeinflusst oder nur unwesentlich beeinflusst.

5. Verfahren nach einem der vorangehenden Ansprüche, wobei die Information alternativ oder zusätzlich einer dezentralen Recheneinheit, insbesondere einer Cloud, bereitgestellt wird.

6. Verfahren nach einem der vorangehenden Ansprüche, wobei das erste Kommunikationsmodul (5a) von der Spannungsquelle (1) mit elektrischer Energie versorgt wird, insbesondere mit dem Analysesignal.

7. Verfahren nach einem der vorangehenden Ansprüche, wobei die Information (9) über eine drahtlose Datenverbindung erfolgt, insbesondere einer Datenverbindung nach einem GSM-Standard, nach einem G3, nach einem G4, nach einem G5-Standard oder mit über einer WLAN Verbindung.

8. Antriebssystem, aufweisend eine Spannungsquelle (1), insbesondere ein Frequenzumrichter, einen Verbraucher (5), insbesondere einen Motor, wobei der Verbraucher (1) durch eine elektrische Leitung (5) mit der Spannungsquelle (1) verbunden ist, wobei dem Verbraucher (5) ein erstes Kommunikationsmodul (5a) zugeordnet ist, wobei die Spannungsquelle (1) zur Bereitstellung eines Analysesignals vorgesehen ist, wobei die elektrische Leitung (3) eine Mehrzahl von Spannungsphasen (u, v, w) umfasst,
wobei das erste Kommunikationsmodul (5a) zu einer Überprüfung einer Anschlussbelegung an dem Verbraucher (5) mit Hilfe des Analysesignals vorgesehen ist, ob die Anschlussbelegung der jeweiligen Spannungsphase (u, v, w) der vorgesehenen Anschlussbelegung entspricht,
wobei das erste Kommunikationsmodul (5a) zur Bereitstellung einer Information (9) anhand der Prüfung vorgesehen ist, wobei ein Anzeigemodul (1) zur Anzeige der Information (9) vorgesehen ist.

9. Antriebssystem nach Anspruch 8, wobei das Anzeigemodul (11) als mobiles Anzeigemodul (11), insbesondere als Smartphone, ausgebildet ist.

10. Antriebssystem nach einem der Ansprüche 8 oder 9, wobei der Verbraucher (5) und/oder das erste Kommunikationsmodul (5a) eine Kennung (7) aufweisen, wobei die Kennung (7) zur Bereitstellung mit der Information (9) vorgesehen ist.

11. Antriebssystem nach einem der Ansprüche 8 bis 10, wobei die Kennung (7) mit dem Anzeigemodul (11) direkt erfassbar ist.

12. Antriebssystem nach einem der Ansprüche 8 bis 11, wobei ein Spannungsteiler (13) zur Spannungsversorgung des ersten Kommunikationsmoduls (5a) vorgesehen ist, wobei der Spannungsteiler (13) an die elektrische Leitung (3) angeschlossen ist.

13. Antriebssystem nach einem der Ansprüche 8 bis 12, wobei die Spannungsquelle (1) ein zweites Kommunikationsmodul (1a) aufweist, wobei das zweite Kommunikationsmodul (1a) zum Empfang der Information (9) ausgebildet ist.

14. Antriebssystem nach einem der Ansprüche 8 bis 13, wobei das erste Kommunikationsmodul (5a) und das zweite Kommunikationsmodul (1a) zur Übertragung von Information (9) über das Anzeigemodul (11) ausgebildet sind.

15. Antriebssystem nach einem der Ansprüche 8 bis 14, wobei das zweite Kommunikationsmodul (1a) einen Energiespeicher (15) aufweist und wobei die elektrische Leitung (3), insbesondere über einen Spannungswandler (13), den Energiespeicher (15) mit Strom versorgt.
